# EUROPEAN PATENT SPECIFICATION

(11) **EP 2 940 698 B1**
(45) Date of publication and mention of the grant of the patent: **30.05.2018**
(21) Application number: 13868055.8
(22) Date of filing: 24.12.2013
(51) Int. Cl.: H01L 39/12, H01L 39/24, H01B 12/06

(54) **RE-123 SUPERCONDUCTING WIRE AND MANUFACTURING METHOD THEREFOR**
SUPRALEITENDER RE-123-DRAHT UND HERSTELLUNGSVERFAHREN DAFÜR
FIL SUPRACONDUCTEUR À BASE DE RE-123 ET PROCÉDÉ DE FABRICATION ASSOCIÉ

(30) Priority: 28.12.2012 JP 2012288718
(43) Date of publication of application: 04.11.2015
(73) Proprietor: Fujikura Ltd., Tokyo 135-8512 (JP)
(72) Inventor: YOSHIDA Tomo, Kawasaki-shi Kanagawa 213-0012 (JP); YOSHIZUMI Masateru, Kawasaki-shi Kanagawa 213-0012 (JP); IZUMI Teruo, Kawasaki-shi Kanagawa 213-0012 (JP); SHIOHARA Yuh, Kawasaki-shi Kanagawa 213-0012 (JP)
(74) Representative: Cabinet Plasseraud
(86) International application number: PCT/JP2013/084441
(87) International publication number: WO 2014/103995

(56) References cited:
- WO-A1-2009/044637
- WO-A1-2013/002372
- JP-A- S6 481 284
- JP-A- 2012 038 526
- US-A1- 2011 009 273
- TOBITA H ET AL: "Fabrication of BaHfO3 doped Gd1Ba2Cu3O7-delta coated conductors with the high Ic of 85 A/cm-w under 3 T at liquid nitrogen temperature (77 K)", SUPERCONDUCTOR SCIENCE AND TECHNOLOGY, vol. 25, no. 6, 062002, 4 May 2012 (2012-05-04), XP020223873, ISSN: 0953-2048, DOI: 10.1088/0953-2048/25/6/062002
- YOKOE D ET AL: "Transmission electron microscopy study of GdBa2Cu3O7-x containing nano-sized BaMO3 (M: Hf, Zr, Sn) rods fabricated by pulsed laser deposition", JOURNAL OF MATERIALS SCIENCE, vol. 48, no. 1, 26 September 2012 (2012-09-26), pages 125-131, XP035153017, ISSN: 1573-4803, DOI: 10.1007/S10853-012-6898-9
- YOSHIDA T ET AL: "Fabrication of Eu1Ba2Cu3O7-delta+BaHfO3 coated conductors with 141 A/cm-w under 3 T at 77 K using the IBAD/PLD process", PHYSICA C, vol. 504, 12 April 2014 (2014-04-12), pages 42-46, XP029007491, ISSN: 0921-4534, DOI: 10.1016/J.PHYSC.2014.03.013
- H TOBITA ET AL.: 'Fabrication of BaHf03 doped Gd1Ba2 Cu 3O7-delta coated conductors with the high Ic of 85 A/cm-w under 3T at liquid nitrogen temperature (77 K' SUPERCONDUCTOR SCIENCE AND TECHNOLOGY vol. 25, page 6, XP055260312

## Description

### TECHNICAL FIELD

The present invention relates to an RE123-based superconducting wire having a superconducting layer into which artificial pinning centers are introduced, and a method of manufacturing the same.

### BACKGROUND ART

An RE123-based oxide superconductor is expressed by a composition formula of RE₁Ba₂Cu₃O_{7-δ} (RE: rare earth element such as Y, Gd), has a critical temperature that is a higher than the temperature of liquid nitrogen (77K).

The above-described oxide superconductor is expected to be applied to superconducting equipment, such as superconducting devices, transformers, fault current limiters, motors, and magnets.

Generally, a superconductor that is formed using an RE123-based oxide superconductor so as to have favorable crystalline orientation exhibits high critical current characteristics under a self-magnetic field.

However, when a magnetic field is applied to a superconductor in a superconducting state and an electric current is applied, a Lorentz force is generated in a quantized magnetic flux that has intruded into the superconductor.

At this time, when the quantized magnetic flux is moved by the Lorentz force, a voltage is generated in the direction of the electric current, and a resistance is caused.

Since the Lorentz force increases as the electric current value increases and as the magnetic field becomes stronger, there is a problem in that the critical current characteristics are degraded as a result of an increase in an external magnetic field.

As a solution for the above problem, it is generally known that nanoscale different phases, such as impurities or defects, are doped into a superconducting layer, and the magnetic flux is pinned (pinning), thereby improving the critical current characteristics of the superconductor under a magnetic field.

As an example, a method of introducing a normal conductor made of an oxidative product containing Ba such as BaZrO₃ as artificial pinning centers into a superconducting layer made of an RE123-based oxide superconductor is known (refer to Patent Document 1).

For example, as a result of introducing the artificial pinning centers of BaZrO₃ into a superconducting layer that is expressed by a composition formula of Y₁Ba₂Cu₃O_{7-δ} (YBCO), the critical current density under a magnetic field can be improved as compared with the case of not introducing artificial pinning centers thereinto (for example, by the improvement, from approximately 0.1 MA/cm² to approximately 0.2 MA/cm² under a magnetic field at 77K and 3T).

### PRIOR ART DOCUMENTS

### PATENT DOCUMENTS

[PATENT DOCUMENT 1]PCT International Publication No. WO 2009/044637 and corresponding US 2011/0009273 A1

[NON-PATENT DOCUMENT 1] H Tobita et al, Superconductor Science and Technology 25 (2012), 062002

### SUMMARY OF INVENTION

### PROBLEMS TO BE SOLVED BY THE INVENTION

As an example of a method of introducing the artificial pinning centers into the aforementioned RE123-based superconducting layer, as described in Patent Document 1, a method is known which dopes trace impurities such as BaZrO₃ thereinto during formation of a superconducting layer by a film formation method such as pulsed laser deposition (PLD method).

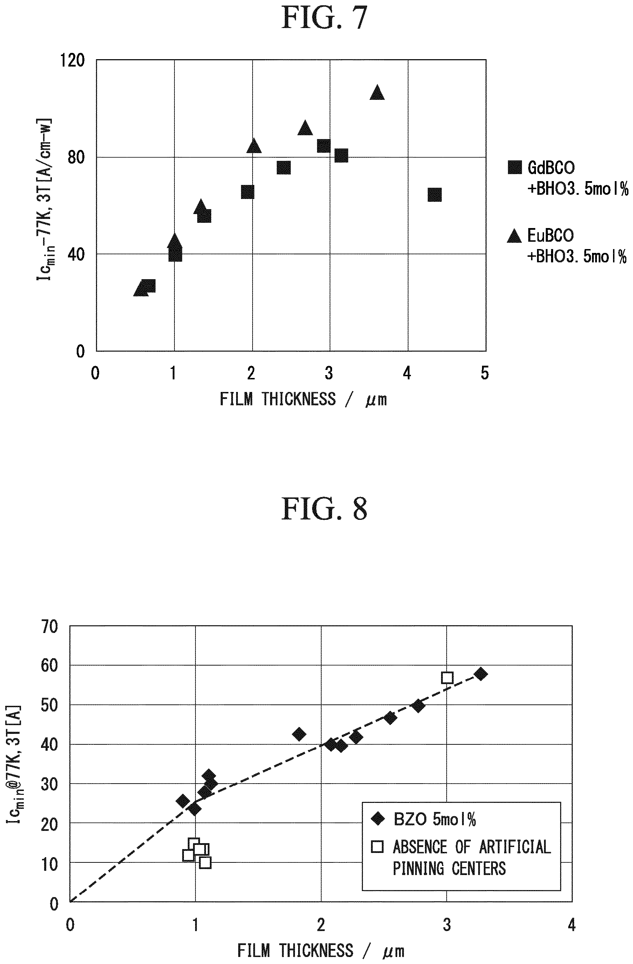

FIG. 8 shows a graph obtained by plotting a critical current minimum value (Icₘᵢₙ) against a film thickness of a GdBa₂Cu₃O_{7-δ} (GdBCO) superconducting layer with regard to an RE123-based superconducting wire produced by a PLD method.

As shown in FIG. 8, by introducing artificial pinning centers of BaZrO₃ (BZO) into the GdBCO superconducting layer, Icₘᵢₙ of the superconducting layer is improved at the film thickness of 1 µm.

However, as the film thickness of the RE123-based superconducting layer becomes thicker, the degree of improvement in the critical current characteristics tends to decrease; regarding a superconducting layer having the film thickness of 3 µm, the characteristics thereof are substantially equal to that in the case where the artificial pinning centers are not introduced.

The reason is believed to be that, in the case of film-forming, by use of a PLD method, the RE123-based superconducting layer into which the artificial pinning centers are introduced, the artificial pinning centers serving as a different phase affects crystal growth of the RE123-based superconducting layer, as the film thickness of the superconducting layer becomes thicker, the degree of crystal orientation of the superconducting layer decreases.

Non-patent document 1 teaches introduction of pinning centers in Gd₁Ba₂Cu₃O_{7-δ} coated conductor wires by doping with 3.5 mol% of BaHfO₃ instead of BZO.

As stated above, regarding an RE123-based superconducting wire, there is a problem in that the critical current value Ic does not linearly increase with respect to the film thickness thereof.

Furthermore, in the case of forming an RE123-based superconducting layer on a static substrate by a PLD method, even in cases where the thickness of the superconducting layer into which the artificial pinning centers are introduced increases, since control of the temperature of a film formation face is relatively easy, the degree of improvement in the critical current characteristics due to introduction of the artificial pinning centers may be maintained.

On the other hand, in order to obtain an RE123-based superconducting wire having a long length, it is necessary to sequentially form a superconducting layer on a substrate by feeding the substrate having a long length in the longitudinal direction of the substrate so as to pass through a film formation area in a film formation apparatus.

However, in the case of sequentially forming the superconducting layer on the substrate that transfers in the film formation apparatus as mentioned above, as the film thickness of the superconducting layer to be formed becomes thicker, it is difficult to control the temperature of the film formation face, it is not easy to maintain optimal conditions for film formation, and it is difficult to obtain the effect of improving the critical current characteristics due to introduction of the artificial pinning centers.

The invention has been made in consideration of the above circumstances, and an object thereof is to provide an RE123-based superconducting wire and a method of manufacturing the same which obtain excellent critical current characteristics under a magnetic field.

### MEANS FOR SOLVING THE PROBLEMS

In order to solve the above-described problems, an RE123-based superconducting wire according to a first aspect of the invention includes: a substrate; an intermediate layer provided above the substrate; and an oxide superconducting layer that is provided above the intermediate layer and is made of an oxide superconductor expressed by a composition formula of Eu₁Ba₂Cu₃O_{7-δ}, wherein BaHfO₃ of 0.5 to 10 mol% is introduced into the oxide superconducting layer, a different phase containing BaHfO₃ is dispersed in the oxide superconducting layer as a flux pinning center, and the percentage of existing a-axis oriented grains in the oxide superconducting layer (a-axial-ratio) is less than or equal to 1.5%.

With the RE123-based superconducting wire according to the first aspect of the invention, since the a-axial-ratio of the oxide superconducting layer is less than or equal to 1.5% and the degree of the c-axis orientation thereof is high, it is possible to obtain a high critical current.

Additionally, since a different phase made of the Hf-containing compound is dispersed in the oxide superconducting layer, the different phase functions as a flux pinning center of the oxide superconducting layer under a magnetic field, and reduction in the critical current due to movement of a quantized magnetic flux is prevented.

Consequently, the RE123-based superconducting wire can provide excellent critical current characteristics under a magnetic field.

Eu₁Ba₂Cu₃O_{7-δ} is less easily influenced by the different phase containing Hf during crystal growth, even in the case where the Hf-containing compound is introduced thereinto and a thick film thereof is thereby formed, the a-axial-ratio thereof can be reliably reduced to be less than or equal to 1.5%.

Accordingly, as a result of using Eu₁Ba₂Cu₃O_{7-δ} as a constituent material of the oxide superconducting layer, it is possible to improve an increase in the critical current by increasing the thickness of the oxide superconducting layer while providing the function of a flux pinning center due to the different phase, and it is possible to obtain a further high level of the critical current characteristics under a magnetic field.

In the RE123-based superconducting wire according to the first aspect of the invention, it is preferable that BaHfO₃ of 1.5 to 5.0 mol% be dispersed in the oxide superconducting layer.

In order to solve the above-described problems, a method of manufacturing an RE123-based superconducting wire according to a second aspect of the invention includes: using a target containing BaHfO₃ of 0.5 to 10 mol% is introduced into an oxide superconductor expressed by a composition formula of Eu₁Ba₂Cu₃O_{7-δ} or powder containing a constituent element of the oxide superconductor; setting a surface temperature of a substrate to 825°C to 875°C; and forming, above an intermediate layer formed above the substrate, by physical vapor deposition, an oxide superconducting layer in which a different phase containing BaHfO₃ is dispersed as a flux pinning center and whose a-axial-ratio is less than or equal to 1.5%.

With the method of manufacturing an RE123-based superconducting wire according to the second aspect of the invention, it is possible to produce an RE123-based superconducting wire providing excellent critical current characteristics under an external magnetic field.

### Effects of the Invention

According to the aspects of the invention, it is possible to obtain the RE123-based superconducting wire obtaining excellent critical current characteristics under a magnetic field.

### BRIEF DESCRIPTION OF THE DRAWINGS

FIG. 1 is a schematic diagram showing an RE123-based superconducting wire according to one embodiment of the invention.
FIG. 2 is a schematic view showing an example of a film formation apparatus for use in a manufacturing method of an RE123-based superconducting wire of the invention.
FIG. 3 is a graph showing the relation between the a-axial-ratio of an oxide superconducting layer and the critical current value (Ic-self) at 77K and in the absence of a magnetic field with regard to Examples 1 and 2.
FIG. 4 is a graph showing the relation between the a-axial-ratio of an oxide superconducting layer and the minimum value (Icₘᵢₙ-3T) of the critical current at 77K and a magnetic field of 3T with regard to Examples 1 and 2.
FIG. 5 is a graph showing the relation between the film thickness of an oxide superconducting layer and the a-axial-ratio thereof with regard to Examples 1 and 3 to 6.
FIG. 6 is a graph showing the relation between the film thickness of an oxide superconducting layer and the critical current value (Ic-self) thereof at 77K and in the absence of a magnetic field with regard to Examples 1 and 3 to 6.
FIG. 7 is a graph showing the relation between the film thickness of an oxide superconducting layer and the minimum value (Icₘᵢₙ-3T) of the critical current thereof at 77K and a magnetic field of 3T with regard to Examples 1 and 3 to 6.
FIG. 8 is a graph showing the relation between the film thickness of a GdBa₂Cu₃O_{7-δ} superconducting layer and the minimum value of the critical current thereof at 77K and a magnetic field of 3T with regard to RE123-based superconducting wire produced by a PLD method.
FIG. 9 is a graph showing the relation between the proportion of an Hf-containing compound contained in each of an EuBCO oxide superconducting layer (film thickness of 1 µm) and a GdBCO oxide superconducting layer (film thickness of 1 µm) and the critical current density thereof.
FIG. 10 is a graph showing the relation between the proportion of an Hf-containing compound contained in each of an EuBCO oxide superconducting layer (film thickness of 3 µm) and a GdBCO oxide superconducting layer (film thickness of 3 µm) and the critical current density thereof.

### EMBODIMENTS FOR CARRYING OUT THE INVENTION

Hereinafter, an RE123-based superconducting wire according to one embodiment of the invention will be described.

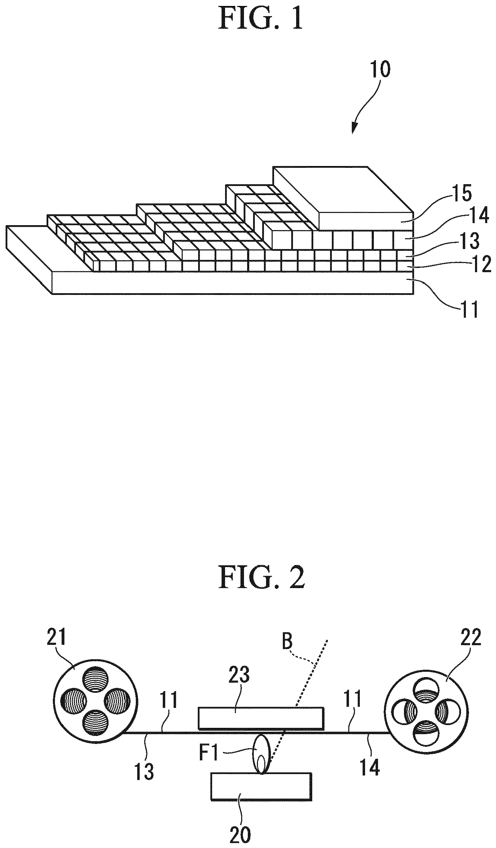

FIG. 1 is a schematic diagram showing RE123-based superconducting wire according to one embodiment of the invention.

The RE123-based superconducting wire 10 shown in FIG. 1 is configured to mainly include: an elongated substrate 11; an intermediate layer 12 formed on the substrate 11; a cap layer 13 formed on the intermediate layer 12; an oxide superconducting layer 14 formed on the cap layer 13; and a stabilizing layer 15 formed on the oxide superconducting layer 14.

In the RE123-based superconducting wire according to the embodiment, a metal material having a tape shape, a plate shape, or a rectangle shape may be adopted as the substrate 11.

As a constituent material used to form the substrate 11, a metal such as Cu, Ni, Ti, Mo, Nb, Ta, W, Mn, Fe, Ag or an alloy made of the aforementioned metal which have a high level of strength and a heat resistance may be used.

A stainless steel, hastelloy (registered trademark), or the other nickel-based alloy which provides excellent corrosion resistance and heat resistance is particularly preferable.

Moreover, an oriented metal substrate such as an oriented Ni-W substrate having nickel alloys or the like into which texture is introduced may be used as the substrate 11.

The thickness of the substrate 11 for use in an oxide superconducting wire may be approximately 0.01 to 0.5 mm.

The intermediate layer 12 is a thin film formed by ion beam assist deposition (IBAD method).

As a constituent material used to form the intermediate layer 12, MgO, GZO (Gd₂Zr₂O₇) YSZ (yttria stabilized zirconia), SrTiO₃ may be adopted as an example.

Among those, a material is more preferably used which makes the value of ΔΦ (220) (FWHM: full width at half maximum) of a half width in the crystal axis distribution in the in-plane direction lower where the half width is an index indicating the degree of crystalline orientation; that is, it is preferable to select a material that can contribute to a high degree of crystal orientation plane direction.

The intermediate layer 12 is formed such that the thickness thereof is, for example, approximately 1 nm to 1 µm.

A method of forming the intermediate layer 12 is not particularly limited.

A diffusion-preventing layer may be formed between the substrate 11 and the intermediate layer 12 for the purpose of preventing chemical elements from being diffused or the like during heat treatment.

The diffusion-preventing layer has a high level of heat resistance, is used to reduce interfacial reactivity, and functions to obtain orientation of the thin-film intermediate layer 12 provided on the diffusion-preventing layer.

Such diffusion-preventing layer is provided as necessary and is made of, for example, GZO (Gd₂Zr₂O₇), yttria (Y₂O₃), silicon nitride (Si₃N₄), alumina (Al₂O₃), or the like.

The diffusion-preventing layer is formed by, for example, a sputtering method or the like such that the thickness thereof is approximately several tens nm to 200 nm.

The diffusion-preventing layer may have a one-layered structure or a two-layered structure.

The cap layer 13 has a function to control orientation of the oxide superconducting layer 14 provided on the cap layer 13 and a function to prevent chemical element forming the oxide superconducting layer 14 from being diffused in the other layers.

The cap layer 13 can obtain a higher degree of in-plane orientation than that of the intermediate layer 12.

As a constituent material of the cap layer 13, it is preferable to use, for example, CeO₂, LMO (LaMnO₃), SrTiO₃, Y₂O₃, Al₂O₃ or the like.

The appropriate film thickness of the cap layer 13 varies with a constituent material of the cap layer 13. For example, in the case of forming the cap layer 13 by CeO₂, the thickness may be in the range of 50 nm to 1 µm or the like.

In the case of film-forming the cap layer 13, it is formed by a PLD method, a sputtering method, or the like; particularly, it is preferable to use a PLD method in terms of obtaining a higher film-forming rate.

The oxide superconducting layer 14 is made of an RE123-based oxide superconductor, an Hf-containing compound is introduced into the layer, and a different phase containing Hf is dispersed in the layer.

The RE123-based oxide superconductor is a substance expressed by a composition formula of RE₁Ba₂Cu₃O_{7-δ} where RE represents one kind of or two or more kinds of rare earth elements in the formula and 6.5<7-δ<7. 1 is satisfied; and wherein RE is Eu.

Additionally, in the case where the RE123-based the oxide superconducting layer 14 is particularly made of Eu₁Ba₂Cu₃O_{7-δ}, the following effect is obtained.

Particularly, regarding the RE123-based oxide superconducting layer in which a different phase is dispersed, since the different phase generally affects crystal growth, as the film thickness becomes thicker, the crystallinity (c-axis orientation) tends to decrease.

In the case where the different phase is an Hf-containing compound, an Eu₁Ba₂Cu₃O_{7-δ} layer that is from among the RE123-based oxide superconducting layers can obtain a high level of crystal orientation even in a relatively thicker film thickness range.

Because of this, as a result of using Eu₁Ba₂Cu₃O_{7-δ} as a constituent material of the oxide superconducting layer 14, it is possible to improve an increase in the critical current by increasing the thickness of the oxide superconducting layer 14 while providing the function of a flux pinning center due to the different phase, and it is possible to obtain a further high level of the critical current characteristics under a magnetic field.

The different phase which is dispersed in the oxide superconducting layer 14 includes Hf, and the different phase serves as a normal conduction part and functions as artificial pinning centers (flux pinning center) that control movement of the quantized magnetic flux in the oxide superconducting layer 14.

The different phase containing Hf serving as artificial pinning centers is formed by doping an Hf-containing compound into the RE123-based oxide superconductor during formation of the oxide superconducting layer 14.

As the Hf-containing compound, BaHfO₃ is adopted. Since BaHfO₃ effectively functions as a pinning center and has a high degree of the effect of preventing reduction in the critical current characteristics due to being applied to an external magnetic field, it is particularly preferable.

The proportion of the Hf-containing compound to be introduced into the RE123-based oxide superconductor is in a range of 0.5 to 10 mol%, preferably in a range of 1.5 to 7.5 mol%, and more preferably in a range of 1.5 to 5.0 mol%.

By use of a deposition material of the RE123-based oxide superconductor to which the Hf-containing compound having the foregoing range of mol% is added, the proportion of the Hf-containing compound in the deposition material (contained amount) is equal to the proportion of a different phase containing Hf (artificial pinning centers) to be introduced into the oxide superconducting layer 14.

For this reason, the different phase containing Hf effectively inhibits movement of the quantized magnetic flux, prevents the critical current from being reduced under a magnetic field, and can provide an RE123-based superconducting wire having excellent critical current characteristics.

In the case where the proportion of the Hf-containing compound to be introduced into the RE123-based oxide superconductor is less than the lower limit (0.5 mol%), there is a possibility that it is difficult to obtain the pinning effect due to the different phase containing Hf that is dispersed therein as artificial pinning centers; furthermore, in the case where the proportion thereof exceeds the upper limit (10 mol%), the proportion of the RE123-based oxide superconductor in the oxide superconducting layer 14 becomes excessively low, there is a possibility that the superconducting characteristics of the RE123-based superconducting wire 10 is degraded.

The different phase in the oxide superconducting layer 14 can be identified by an XRD (X-ray diffraction) method or an electron beam diffraction method.

The composition ratio of the oxide superconducting layer 14 can be identified by, for example, ICP emission spectrochemical analysis.

Moreover, the configuration or the rod diameter of the different phase in the oxide superconducting layer 14 can be identified by observing the cross-section thereof using a transmission electron microscope (TEM).

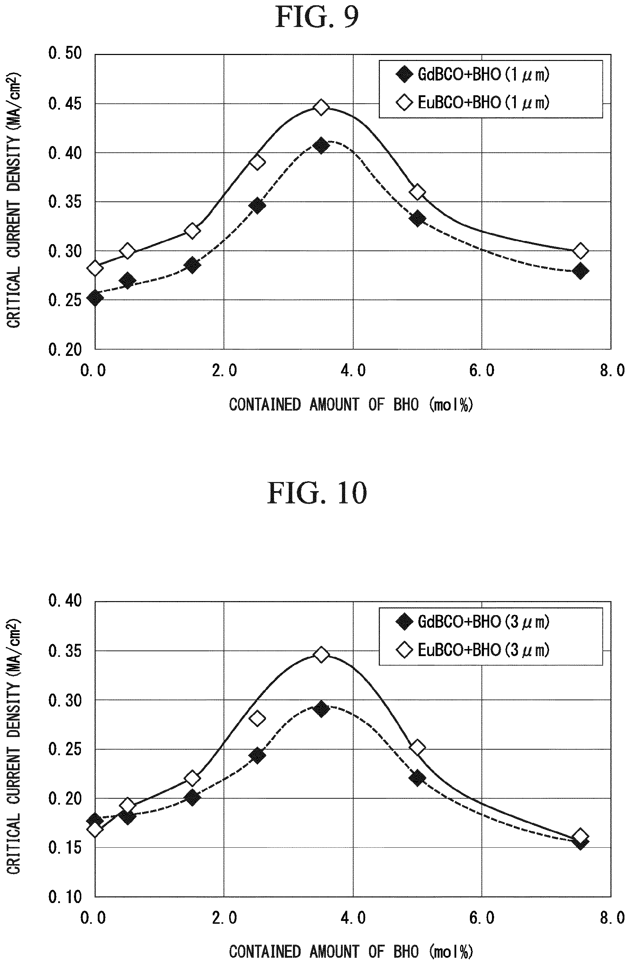

FIGS. 9 and 10 are graphs showing verification of the proportion (contained amount) of the Hf-containing compound (BHO).

FIG. 9 is a graph showing the relation between the proportion of an Hf-containing compound contained in each of an EuBCO oxide superconducting layer (film thickness of 1 µm) and a GdBCO oxide superconducting layer (film thickness of 1 µm) and the critical current density thereof (a magnetic field of 3T).

The vertical axis represents the critical current density (MA/cm²), the horizontal axis represents the contained amount (mol%) of the Hf-containing compound (BHO).

In the case where the contents of BHO contained in the EuBCO oxide superconducting layer and the GdBCO oxide superconducting layer vary from 0 mol% to 7.5 mol%, the critical current density was determined.

As the contained amount of BHO increases from 0 mol% to 3.5 mol%, the critical current densities of the EuBCO oxide superconducting layer and the GdBCO oxide superconducting layer increased.

In contrast, as the contained amount of BHO increases from 3.5 mol% to 7.5 mol%, the critical current densities of the EuBCO oxide superconducting layer and the GdBCO oxide superconducting layer decreased.

In the case where the proportion of BHO is 3.5 mol%, the critical current density in the EuBCO oxide superconducting layer was approximately 0.45 MA/cm², and the critical current density in the GdBCO oxide superconducting layer was approximately 0.41 MA/cm².

Particularly, the critical current density significantly increased in the range of 2 to 5 mol%.

The result of the critical current densities corresponding to FIG. 9 is shown in Table 1.

**(Table 1)**

| BHO IS CONTAINED IN GdBCO OXIDE SUPERCONDUCTING LAYER (FILM THICKNESS OF 1 *µ*m) | | | | | | | |
|---|---|---|---|---|---|---|---|
| BHO IS CONTAINED IN EuBCO OXIDE SUPERCONDUCTING LAYER (FILM THICKNESS OF 1 *µ*m) | | | | | | | |
| CONTAINED AMOUNT OF BHO (mol%) | 0 | 0.5 | 1.5 | 2.5 | 3.5 | 5 | 7.5 |
| CRITICAL CURRENT DENSITY IN GdBCO (MA/cm²) | 0.253 | 0.270 | 0.286 | 0.346 | 0.407 | 0.333 | 0.280 |
| CRITICAL CURRENT DENSITY IN EuBCO (MA/cm²) | 0.283 | 0.300 | 0.320 | 0.390 | 0.446 | 0.360 | 0.300 |

FIG. 10 is a graph showing the relation between the proportion of an Hf-containing compound contained in each of an EuBCO oxide superconducting layer (film thickness of 3 µm) and a GdBCO oxide superconducting layer (film thickness of 3 µm) and the critical current density thereof (a magnetic field of 3T).

The vertical axis represents the critical current density (MA/cm²), the horizontal axis represents the contained amount (mol%) of the Hf-containing compound (BHO).

In the case where the contents of BHO contained in the EuBCO oxide superconducting layer and the GdBCO oxide superconducting layer vary from 0 mol% to 7.5 mol%, the critical current density was determined.

As the contained amount of BHO increases from 0 mol% to 3.5 mol%, the critical current densities of the EuBCO oxide superconducting layer and the GdBCO oxide superconducting layer increased.

In contrast, as the contained amount of BHO increases from 3.5 mol% to 7.5 mol%, the critical current densities of the EuBCO oxide superconducting layer and the GdBCO oxide superconducting layer decreased.

In the case where the proportion of BHO is 3.5 mol%, the critical current density in the EuBCO oxide superconducting layer was approximately 0.35 MA/cm², and the critical current density in the GdBCO oxide superconducting layer was approximately 0.29 MA/cm².

Particularly, the critical current density significantly increased in the range of 2 to 5 mol%.

The result of the critical current densities corresponding to FIG. 10 is shown in Table 2.

**(Table 2)**

| BHO IS CONTAINED IN GdBCO OXIDE SUPERCONDUCTING LAYER (FILM THICKNESS OF 3 *µ*m) | | | | | | | |
|---|---|---|---|---|---|---|---|
| BHO IS CONTAINED IN EuBCO OXIDE SUPERCONDUCTING LAYER (FILM THICKNESS OF 3 *µ*m) | | | | | | | |
| CONTAINED AMOUNT OF BHO (mol%) | 0 | 0.5 | 1.5 | 2.5 | 3.5 | 5 | 7.5 |
| CRITICAL CURRENT DENSITY IN GdBCO (MA/cm²) | 0.176 | 0.180 | 0.200 | 0.242 | 0.291 | 0.220 | 0.155 |
| CRITICAL CURRENT DENSITY IN EuBCO (MA/cm²) | 0.167 | 0.190 | 0.220 | 0.280 | 0.345 | 0.250 | 0.160 |

As the different phase containing Hf that is dispersed in the oxide superconducting layer 14 and serves as a flux pinning center (artificial pinning centers), hafnium oxide compound MHfO₃ (M represents Ba, Sr, or Ca in the formula) and HfO₂ is adopted, and specifically, BaHfO₃, SrHfO₃, CaHfO₃, and HfO₂ is adopted.

As described above, in the case where the Hf-containing compound to be introduced into the RE123-based oxide superconductor is BaHfO₃, as the artificial pinning centers serving as the different phase containing Hf, BaHfO₃, and HfO₂ is adopted.

The different phase containing Hf in the oxide superconducting layer 14 is mainly BaHfO₃ in the case where BaHfO₃ or HfO₂ is introduced thereinto as the Hf-containing compound.

Moreover, the flux pinning center (artificial pinning centers) dispersed in the oxide superconducting layer 14 may include not only the above-described compounds but also a normal conductor such as RE₁₊ₓBa₂₋ₓCu₃O_{7-δ} which is produced by modification of the composition of the RE123-based superconductor or BaO, SrO, CaO, or the like which is the oxidative product of the M.

The proportion of the different phase containing Hf that is dispersed in the oxide superconducting layer 14 and serves as artificial pinning centers is substantially equal to the proportion of the Hf-containing compound which is introduced into the RE 123-based oxide superconductor that is a film forming material.

Consequently, similar to the additive amount of the Hf-containing compound in the film forming material, the proportion of the different phase containing Hf in the oxide superconducting layer 14 is preferably in a range of 0.5 to 10 mol%, more preferably in a range of 1.5 to 7.5 mol%, and further preferably in a range of 1.5 to 5.0 mol%.

The thickness d of the oxide superconducting layer 14 is larger than 1 µm, preferably in a range of 1 to 10 µm, and more preferably in a range of 1 to 5 µm.

In addition, it is preferable that the oxide superconducting layer 14 have a uniform thickness.

Particularly, in the RE123-based superconducting wire 10 according to the embodiment of the invention, as mentioned above, the different phase in the Hf-containing compound is dispersed in the oxide superconducting layer 14 as a flux pinning center, and the a-axial-ratio of the oxide superconducting layer 14 is defined so as to be less than or equal to 1.5%.

Here, the a-axial-ratio means the value calculated by the peak intensity ratio of (200) peak to (006) peak which is observed by X-ray diffraction measurement using a θ-2θ method and is "(200) peak intensity / (006) peak intensity) × 100 (%)".

The a-axial-ratio serves as an indicator of c-axis orientation in the oxide superconducting layer 14.

That is, the a-axial-ratio is less than or equal to 1.5%, and this means that 98.5% or more of the crystals which constitute the oxide superconducting layer 14 are oriented in the c-axis, the only crystals corresponding to the remaining portion of 1.5% or less are oriented in the a-axis, and the degree of c-axis orientation of the oxide superconducting layer 14 is high.

According to the embodiment of the invention, since the degree of the c-axis orientation of the oxide superconducting layer 14 is high, a high critical current is obtained, the different phase efficiently functions as a flux pinning center under an external magnetic field, and it is possible to obtain a high level of the critical current characteristics.

The oxide superconducting layer 14 can be stacked in layers on the cap layer 13 by: physical vapor deposition such as a sputtering method, a vacuum deposition method, a laser deposition method, or an electron beam deposition method; a chemical vapor deposition method (CVD method); a metal organic deposition method (MOD method); or the like.

Among the above methods, from the viewpoint of productivity, a pulsed laser deposition method (PLD method), a TFA-MOD method (an organic metal deposition method in which trifluoroacetate is used, dipping-pyrolysis process), or a CVD method is preferably used, and a PLD method is more preferably used.

Particularly, among those, by use of physical vapor deposition, it is preferable that film formation be carried out while maintaining a surface temperature of a substrate to be 825 to 875°C in term of obtaining the oxide superconducting layer 14 having the a-axial-ratio of 1.5% or less.

The MOD method is a method in which a metallic organic salt is coated and then thermally decomposed. After a solution containing an organic compound having metallic components uniformly dissolved therein is coated on a substrate, the solution is heated and thermally decomposed, thereby forming a thin film on the substrate.

Since a vacuum process is not required, and a film can be rapidly formed at a low cost, this method is appropriate for manufacturing a tape-shaped elongated oxide superconducting conductor.

Moreover, by controlling the composition of a raw material solution, it is possible to control the introduction proportion of the different phase containing Hf in the formed oxide superconducting layer 14.

Regarding chemical vapor deposition, by controlling the kinds of source material gases or the flow rate thereof, it is possible to control the introduction proportion of the different phase containing Hf in the formed oxide superconducting layer 14.

Regarding a PLD method, by controlling the compositional ratio of the target for use therein, it is possible to control the introduction proportion of the different phase containing Hf in the formed oxide superconducting layer 14.

In the case of forming the oxide superconducting layer 14 using the aforementioned methods, by controlling the compositional ratio of raw materials so that the Hf-containing compound of the range of 0.5 to 10 mol%, preferably the range of 1.5 to 7.5 mol%, more preferably the range of 1.5 to 5.0 mol% is introduced into the RE123-based oxide superconductor expressed by the composition formula of RE₁Ba₂Cu₃O_{7-δ}, it is possible to form a thin film (the oxide superconducting layer 14) to which the compositional ratio is reflected.

Specifically, for example, in the case of forming a film by a PLD method, it is preferable to use a target that is sintered and obtained by mixing the powder of an Hf-containing compound such as hafnium oxide compound MHfO₃ by 0.5 to 10 mol% into the powder of the RE123-based oxide superconductor expressed by the composition formula of RE₁Ba₂Cu₃O_{7-δ} or into the powder including the constituent element of the RE123-based oxide superconductor.

Furthermore, as the target, a sintered body may be used which is sintered and obtained by mixing the powder including the constituent element of hafnium oxide compound MHfO₃ (for example, HfO₂ or the like) into the powder of the RE123-based oxide superconductor expressed by the composition formula of RE₁Ba₂Cu₃O_{7-δ} or into the powder including the constituent element of the RE123-based oxide superconductor so that the content of Hf is 0.5 to 10 mol%.

In the embodiment of the invention, from among the aforementioned methods, it is particularly preferable to form the oxide superconducting layer 14 by a PLD method.

Hereinbelow, as a method of manufacturing an RE123-based superconducting wire according to one embodiment of the invention, the case of forming the oxide superconducting layer 14 by a PLD method will be described.

FIG. 2 is a schematic perspective view showing an example of a laser deposition apparatus that is used to form an oxide superconducting layer 14 by a PLD method.

Particularly, before film-forming the oxide superconducting layer 14 using the laser deposition apparatus, each of a diffusion-preventing layer, an intermediate layer 12, and a cap layer 13 is previously formed on a substrate 11 by the above-described film formation method.

Thereafter, the oxide superconducting layer 14 can be formed by the laser deposition apparatus shown in FIG. 2.

The laser deposition apparatus shown in FIG. 2 is provides with a decompression container to which a decompression device such as a vacuum pump is connected and is configured to be capable of irradiating a target 20 placed in the decompression container with a laser beam B emitted from a laser beam irradiation apparatus provided outside the decompression container.

Additionally, a feed reel 21, a winding reel 22, and a plate-shaped heating apparatus 23 located at intermediate position the reels 21 and 22 are provided inside the decompression container.

The tape-shaped substrate 11 can be transferred from the feed reel 21 toward the winding reel 22 through the heating apparatus 23.

In the laser deposition apparatus, the substrate 11 is heated by the heating apparatus 23 so as to be a predetermined film deposition temperature, the particles generated from the target 20 due to the laser beam B are deposited on the substrate 11 during transferring of the substrate 11, and it is thereby possible to form a film on the substrate 11.

As described above, the target 20 is made of a plate material such as a sintered body that is obtained by introducing an Hf-containing compound such as MHfO₃ by a desired proportion into: the composition that is equal to or approximated to the oxide superconducting layer 14 to be formed; composite oxide containing a large amount of a component that easily escape during film formation; or an RE123-based oxide superconductor.

In the laser deposition apparatus the configuration shown in FIG. 2, a film formation is carried out while transferring the substrate 11 by a transportation speed of, for example, 2 to 200 m/h in the longitudinal direction thereof, heating the substrate 11 to a suitable temperature that is a film deposition temperature at which the oxide superconducting layer 14 is formed (for example, 700 to 1000°C).

Moreover, if required, an oxygen atmosphere is maintained in the decompression container by introducing an oxygen gas into the container, and the film formation may be carried out.

As a temperature condition during the film formation, the substrate surface temperature is preferably in the range of 825 to 875°C.

As a result of forming a film while performing temperature control of a heater inside the film formation apparatus so as to be in this temperature range, it is possible to make the a-axial-ratio less than or equal to 1.5%.

The deposition particles as a plume F1, which are sputtered or evaporated from the target 20 by irradiating the target 20 with the laser beam B, are deposited on the surface of the cap layer 13 on the substrate 11 that passes through the area facing the target 20, and the oxide superconducting layer 14 is thereby formed.

According to the method of forming a form by a PLD method while transferring the substrate in the longitudinal direction of the substrate shown in the laser deposition apparatus shown in FIG. 2, since it is possible to produce the RE123-based superconducting wire 10 having a long length with a high level of productivity, it is preferable.

In a conventional superconducting wire, artificial pinning centers of BaZrO₃ are introduced into an RE123-based oxide superconducting layer.

Specifically, in the case of using a PLD method carrying out continuous film deposition while transferring the substrate having a long length using an apparatus shown in FIG. 2 and of film-forming an oxide superconducting layer constituting a conventional superconducting wire, as shown in FIG. 8, as the film thickness of the oxide superconducting layer increases, the degree of the effect due to introduction of the artificial pinning centers decreases, the degree of improvement in the critical current value tends to decrease.

In contrast, in the RE123-based superconducting wire 10 according to the embodiment, even in cases where film formation of the oxide superconducting layer 14 having a large thickness is carried out by a PLD method while transferring the substrate, it is possible to prevent the degree of the effect due to the introduction of the artificial pinning centers depending on an increase in thickness of the oxide superconducting layer 14 from decreasing, and it is possible to provide a high level of the critical current characteristics.

It is preferable that the stabilizing layer 15 be stacked in layers above the oxide superconducting layer 14 as shown in FIG. 1.

In the case where part of the oxide superconducting layer 14 is about to transform into a normal conduction state, the stabilizing layer 15 that is stacked in layers on the oxide superconducting layer 14 functions as a current bypass that circulates an electrical current flowing in the oxide superconducting layer 14.

The stabilizing layer 15 is a main constituent element of the superconducting wire 10 which stabilizes the oxide superconducting layer 14 and causes it not to be burned out.

The stabilizing layer 15 is preferably made of a high electroconductive metal, and specifically, silver, a silver alloy, copper, or the like may be used as an example.

The structure of the stabilizing layer 15 may be a single structure or a laminated structure of two or more layers.

A well-known method is used as a method of laminating the stabilizing layer 15, and a method of forming a silver layer by plating or by a sputtering method and thereby adhesively attaching a copper tape or the like on the silver layer can be employed.

The thickness of the stabilizing layer 15 can be in a range of 3 to 300 µm.

As described above, the RE123-based superconducting wire 10 according to the embodiment, since the a-axial-ratio of the oxide superconducting layer 14 is less than or equal to 1.5% and the degree of the c-axis orientation of the oxide superconducting layer 14 is high, it is possible to obtain a high critical current.

Additionally, since a different phase containing Hf is dispersed in the oxide superconducting layer 14, the different phase functions as a flux pinning center of the oxide superconducting layer 14 under an external magnetic field, and reduction in the critical current due to movement of a quantized magnetic flux is prevented.

Consequently, the RE123-based superconducting wire 10 can provide excellent critical current characteristics under an external magnetic field.

Particularly, in the case where the oxide superconducting layer 14 is made of Eu₁Ba₂Cu₃O_{7-δ}, even where the oxide superconducting layer 14 is formed so as to be made thicker, the a-axial-ratio of the oxide superconducting layer 14 can be reliably reduced to be less than or equal to 1.5%.

As a result, it is possible to improve an increase in the critical current by increasing the thickness of the oxide superconducting layer 14 while providing the function of a flux pinning center due to the different phase to the oxide superconducting layer 14, and it is possible to obtain a further high level of the critical current characteristics under an external magnetic field.

Furthermore, according to the method of manufacturing an RE123-based superconducting wire of the aforementioned embodiment of the invention, it is possible to provide the RE123-based superconducting wire 10 obtaining excellent critical current characteristics under an external magnetic field.

In the above-description, the RE123-based superconducting wire according to one embodiment of the invention is described; however, the configuration of the RE123-based superconducting wire and the manufacturing method thereof in the above-mentioned embodiment is shown as an example, various modifications may be made insofar as they do not depart from the scope of the present invention.

### Examples

Hereinbelow, the invention will be particularly described with reference to Examples; however, the invention is not limited to the Examples.

### (Production of Substrate used in Superconducting Wire)

In Examples, the configuration described below is adopted as that of a substrate used in a superconducting wire.

A substrate which has the width of 10 mm, the thickness of 0.1 mm, and the length of 10 cm and is made of hastelloy C276 (trade name of Haynes International, Inc., United States) was prepared.

A Gd₂Zr₂O₇ (GZO) layer having the thickness of 110 nm was formed on the substrate by a sputtering method, and furthermore, MgO having the thickness of 3 nm was formed on the GZO layer by an IBAD method, and thereby an intermediate layer was formed.

Subsequently, an LaMnO₃ (LMO) having the thickness of 8 nm was formed on the MgO layer by a sputtering method, a CeO₂ layer having the thickness of 500 nm was formed on the LMO layer by a PLD method, and a cap layer was thereby formed on the intermediate layer.

The substrate used in the superconducting wire was produced by the above described steps.

### (Example 1)

An EuBa₂Cu₃O_{7-δ} oxide superconducting layer (EuBCO oxide superconducting layer) having the film thickness of 0.6 µm was formed on the CeO₂ layer of the above-mentioned produced the substrate used in the superconducting wire by a PLD method using the laser deposition apparatus shown in FIG. 2 in the following steps.

An elongated metal substrate was wound around a feed reel of the laser deposition apparatus shown in FIG. 2 as a dummy substrate, the end of the elongated metal substrate was drawn therefrom, the end of the elongated metal substrate was fixed to a winding reel, and the elongated metal substrate was arranged between the paired reels so that the elongated metal substrate can be fed in the longitudinal direction thereof from the feed reel toward the winding reel.

Next, in view of the elongated metal substrate that is arranged between the paired reels and serves as a dummy substrate, the aforementioned produced substrate used in the superconducting wire was fixed on the outer surface of the elongated metal substrate that is wound around the feed reel so that the CeO₂ layer of the substrate used in the superconducting wire serves as a surface on which a film is to be formed.

Subsequently, the feed reel and the winding reel were coordinately driven, the elongated metal substrate was fed in the longitudinal direction thereof, the substrate used in the superconducting wire fixed on the elongated metal substrate was transferred from the feed reel toward the winding reel, and an Eu-123-based oxide superconducting layer having the film thickness of 0.6 µm was formed on the CeO₂ layer of the substrate used in the superconducting wire while the substrate used in the superconducting wire passing through a film formation area opposed to a target.

Particularly, in the step of film-forming the oxide superconducting layer, the target was used which is obtained by sintering the powder in which BaHfO₃ (BHO) is mixed by 3.5 mol% into the power of EuBa₂Cu₃O_{7-δ}, and the substrate was subjected to the film formation area so as to pass therethrough two or more times while repeatedly changing the transfer directions of the substrate under the atmosphere where the substrate surface temperature is 840°C, the pressure is 80 Pa, the laser output is 34 W, and oxygen is 100% and under the condition where the transportation speed of the substrate used in the superconducting wire is 20 m/h.

As a result of measuring the a-axial-ratio of the produced oxide superconducting layer by X-ray diffraction measurement using a θ-2θ method, the ratio was 0.8%.

Next, Ag (stabilizing layer) having the thickness of 5 µm was formed on the oxide superconducting layer by sputtering, and an RE123-based superconducting wire was thereby produced.

### (Example 2)

An RE123-based superconducting wire was produced in the same manner as that in Example 1 except that the substrate surface temperature during formation of the oxide superconducting layer is changed to 830°C and the oxide superconducting layer having the a-axial-ratio of 1.3% is formed.

Regarding the RE123-based superconducting wires of Examples 1 and 2, the critical current characteristics at 77K and in the absence of a magnetic field and the critical current characteristics at 77K and a magnetic field of 3T were measured.

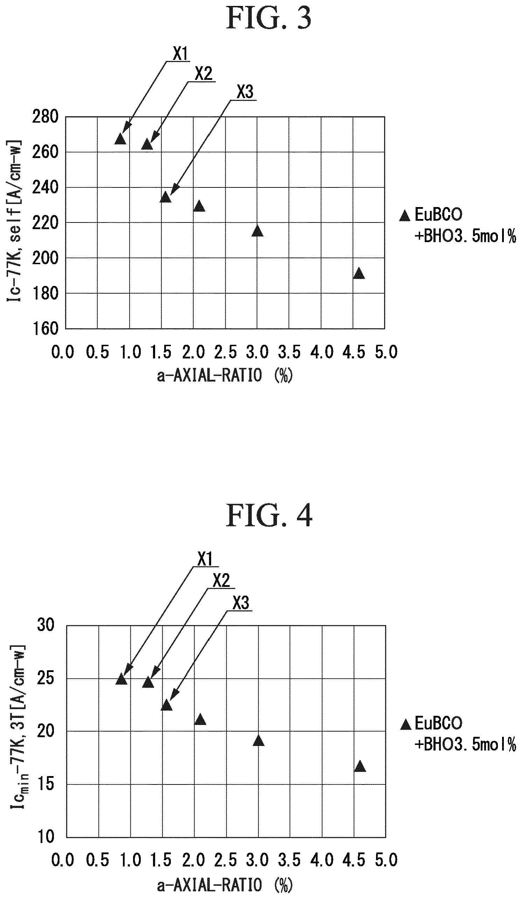

FIG. 3 shows the result of plotting the critical current value (Ic-self, "Ic-77K, self" is shown in FIG. 3 on the y-axis) at 77K and in the absence of a magnetic field against the a-axial-ratio of the oxide superconducting layer.

FIG. 4 shows the result of plotting the minimum value of the critical current (Icₘᵢₙ-3T, "Icₘᵢₙ-77K, 3T" is shown in FIG. 4 on the y-axis) at 77K and a magnetic field of 3T against the a-axial-ratio of the oxide superconducting layer.

Moreover, reference signs X1 to X3 indicated in FIGS. 3 and 4 represent the critical current characteristics in the case of varying the substrate surface temperature during formation of the oxide superconducting layer.

Reference sign X1 represents the critical current characteristics in the case where the substrate surface temperature is 840°C (Example 1).

Additionally, reference sign X2 represents the critical current characteristics in the case where the substrate surface temperature is 830°C (Example 2).

Furthermore, reference sign X3 represents the critical current characteristics in the case where the substrate surface temperature is 820°C (Comparative Example).

Moreover, three plots (three critical current characteristics) which are located at the right side of reference sign X3 represent the critical current characteristics in the case of the substrate surface temperature lower than 820°C (Comparative Example).

Specifically, the three plots represent the critical current characteristics in the case where the substrate surface temperature are 810°C, 800°C, and 790°C in order from reference sign X3 to the right side of the graph.

It is understood from the results of FIGS. 3 and 4 that both Ic-self and Icₘᵢₙ-3T sharply decrease in the case where the a-axial-ratio of the oxide superconducting layer becomes greater than 1.5%.

For this reason, it is found that, the a-axial-ratio of the oxide superconducting layer is the essential element that controls the critical current characteristics, it is possible to realize the oxide superconducting wire obtaining a high level of the critical current characteristics under a magnetic field as a result of determining the a-axial-ratio to be less than or equal to 1.5%.

Particularly, in view of the substrate surface temperature during formation of the oxide superconducting layer, in the case where the substrate temperature is 840°C or 830°C as indicated reference signs X1 and X2 shown in FIGS. 3 and 4, the a-axial-ratio is low and a higher critical current Ic is obtained.

On the other hand, in the case where the substrate temperature is 820°C as indicated by reference sign X3, the a-axial-ratio is high and the critical current Ic decreases.

Furthermore, in the case where the substrate surface temperature is lower than 820°C, the a-axial-ratio is higher and the critical current Ic becomes lower.

In particular, in the case where the substrate temperature exceeds 875°C, there is a problem in that, the elements constituting the substrate are diffused in the superconducting wire, a passivation layer is broken and the oxide superconducting layer does not function.

Therefore, it is necessary to set the substrate temperature to be less than or equal to 875°C.

From the above results, it is preferable that the substrate surface temperature during formation of the oxide superconducting layer be 825°C (intermediate between 820°C and 830°C) to 875°C.

### (Examples 3 to 6)

The film thickness of the oxide superconducting layer was changed from 0.6 µm (Example 1), to 1.3 µm (Example 3), to 2.0 µm (Example 4), to 2.7 µm (Example 5), and to 3.6 µm (Example 6), and each of RE123-based superconducting wires of Examples 3 to 6 was produced.

Each of RE123-based superconducting wires of Examples 3 to 6 was produced under the same film formation conditions as that in Example 1 except that the film thickness of the oxide superconducting layer is changed.

With regard to each of the RE123-based superconducting wire of Examples 1 and 3 to 6, the a-axial-ratio of the oxide superconducting layer, the critical current characteristics at 77K and in the absence of a magnetic field, and the critical current characteristics at 77K and a magnetic field of 3T were measured.

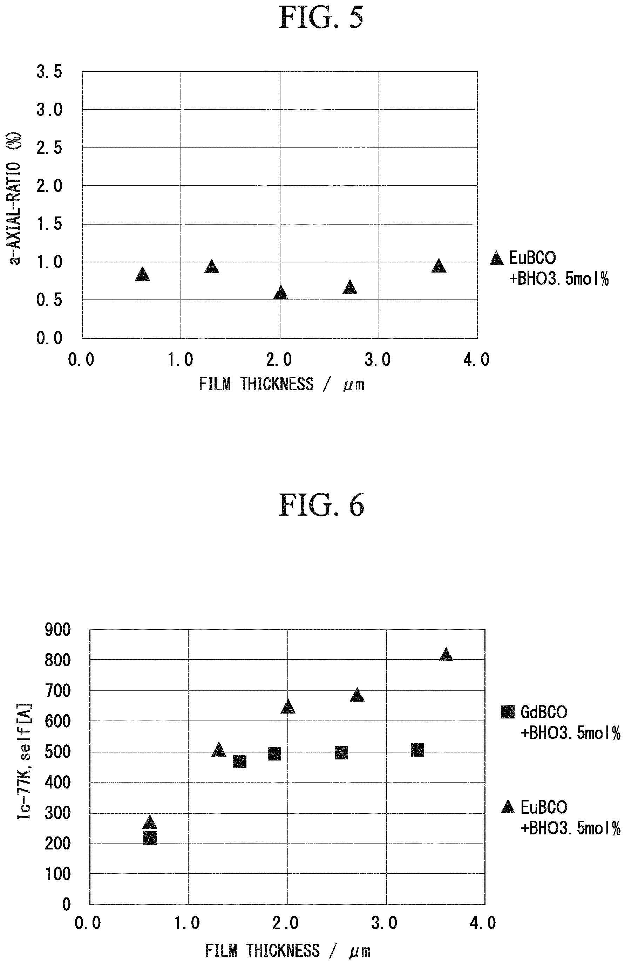

FIG. 5 shows the result of plotting the a-axial-ratio against the film thickness of the oxide superconducting layer that is changed in the above-described manner.

FIG. 6 shows the result of plotting the critical current value (Ic-self, "Ic-77K, self" is shown in FIG. 6 on the y-axis) that is measured at 77K and in the absence of a magnetic field against the film thickness of the oxide superconducting layer that is changed in the above-described manner.

FIG. 7 shows the result of plotting the minimum value of the critical current (Icₘᵢₙ-3T, "Icₘᵢₙ-77K, 3T" is shown in FIG. 7 on the y-axis) that is measured at 77K and a magnetic field of 3T against the film thickness of the oxide superconducting layer that is changed in the above-described manner.

Additionally, FIGS. 6 and 7 show the critical current value (Ic-77K, self and Icₘᵢₙ-77K, 3T) of the superconducting wire including a GdBCO superconducting layer.

In the FIGS. 6 and 7, the critical current characteristics, which are obtained by changing the film thickness of the GdBCO superconducting layer, producing the superconducting wire, and measuring the critical current thereof, are plotted against the film thickness thereof.

It is understood from the result shown in FIG. 5 that, the a-axial-ratio of the oxide superconducting layer (EuBCO oxide superconducting layer) is less than 1.5% and less than or equal to 1.0% in all cases of the film thicknesses.

Furthermore, as evidenced by the results shown in FIGS. 6 and 7, as the film thickness of the oxide superconducting layer EuBCO becomes thicker, the Ic-self and Icₘᵢₙ-3T substantially linearly increases, and the critical current of 107A under a magnetic field of 3T is realized.

Particularly, it can be understood that the value is a significantly excellent value even in a superconducting wire including an REBCO-based oxide superconducting layer having a pinning structure introduced thereinto in practice.

As an example, a superconducting wire will be described which includes a GdBCO oxide superconducting layer which is generally referred to as REBCO and into which a pinning structure is introduced where the pinning structure has a BZO that generally serves as the artificial pinning centers shown in FIG. 8 and serves as a different phase.

Regarding this superconducting wire, the Icₘᵢₙ-3T thereof is approximately 60A at the film thickness of approximately 3 µm, in contrast, the superconducting wire including the oxide superconducting layer having the film thickness of 3.6 µm exhibits 107A as shown in FIG. 7, and therefore it can be understood that the value is a significantly excellent value.

For this reason, in the EuBCO oxide superconducting layer in which BHO is dispersed as a different phase, it is found that, even in the case where the film thickness is thick, it is difficult for the a-axial-ratio to deteriorate, and it is possible to obtain significantly excellent critical current characteristics under a magnetic field which is coupled with a pinning effect due to the BHO as a result of making the film thickness thicker.

It is understood from the result shown in FIG. 6 that the superconducting wire including the EuBCO superconducting layer provides the critical current characteristics superior to that of the superconducting wire including the GdBCO superconducting layer.

Particularly, in the superconducting wire including the EuBCO superconducting layer, the result that the critical current value increases with an increase in the film thickness is obtained.

In contrast, in the superconducting wire including the GdBCO superconducting layer, even in the case where the film thickness increases, the result that the critical current value does not exceed 600A is obtained.

It is understood from the result shown in FIG. 7 that the superconducting wire including the EuBCO superconducting layer provides the critical current characteristics superior to that of the superconducting wire including the GdBCO superconducting layer.

Particularly, in the superconducting wire including the EuBCO superconducting layer, the result that the minimum value of the critical current increases with an increase in the film thickness is obtained.

On the other hand, in the superconducting wire including the GdBCO superconducting layer, the minimum value of the critical current increases with an increase in the film thickness in the film thickness range of 0 to 3 µm; however, when the film thickness exceeds 3 µm, the result that the minimum value of the critical current decreases is obtained.

### DESCRIPTION OF REFERENCE NUMERAL

10···RE123-based superconducting wire, 11···substrate, 12···intermediate layer, 13···cap layer, 14···oxide superconducting layer, 15···stabilizing layer, 20···target, 21··· feed reel, 22···winding reel, 23···heating apparatus.

## Claims

1. An RE123-based superconducting wire (10) comprising:
a substrate (11);
an intermediate layer (12) provided above the substrate (11); and
an oxide superconducting layer (14) that is provided above the intermediate layer (12),
**characterized in that** said oxide superconducting layer (14) is made of an oxide superconductor expressed by a composition formula of Eu₁Ba₂Cu₃O_{7-δ}, wherein
BaHfO₃ of 0.5 to 10 mol% is introduced into the oxide superconducting layer (14),
a different phase containing BaHfO₃ is dispersed in the oxide superconducting layer (14) as a flux pinning center, and
the a-axial-ratio of the oxide superconducting layer is less than or equal to 1.5%.

2. The RE123-based superconducting wire (10) according to claim 1, wherein the BaHfO₃ of 1.5 to 5.0 mol% is introduced into the oxide superconducting layer (14).

3. A method of manufacturing an RE123-based superconducting wire (10), comprising:
using a target (20) containing BaHfO₃ of 0.5 to 10 mol% which is introduced into an oxide superconductor expressed by a composition formula of Eu₁Ba₂Cu₃O_{7-δ}; or powder containing a constituent element of the oxide superconductor;
setting a surface temperature of a substrate (11) to 825°C to 875°C; and
forming, above an intermediate layer (12) formed above the substrate (11), by physical vapor deposition, an oxide superconducting layer (14) in which a different phase containing BaHfO₃ is dispersed as a flux pinning center and whose a-axial-ratio is less than or equal to 1.5%.

## Patentansprüche

1. RE123-basierter supraleitender Draht (10), der Folgendes umfasst:
ein Substrat (11);
eine Zwischenschicht (12), die oberhalb des Substrats (11) bereitgestellt ist; und
eine supraleitende Oxidschicht (14), die oberhalb der Zwischenschicht (12) bereitgestellt ist,
**dadurch gekennzeichnet, dass** die supraleitende Oxidschicht (14) aus einem Oxidsupraleiter gefertigt ist, der durch eine Zusammensetzungsformel von Eu₁Ba₂Cu₃O_{7-δ} ausgedrückt wird, wobei
BaHfO₃ von 0,5 bis 10 Mol-% in die supraleitende Oxidschicht (14) eingeführt ist,
eine andere Phase, die BaHfO₃ enthält, in der supraleitenden Oxidschicht (14) als ein Flussverankerungszentrum dispergiert ist, und
das a-axiale Verhältnis der supraleitenden Oxidschicht kleiner als oder gleich 1,5 % ist.

2. RE123-basierter supraleitender Draht (10) nach Anspruch 1, wobei das BaHfO₃ von 1,5 bis 5,0 Mol-% in die supraleitende Oxidschicht (14) eingeführt ist.

3. Verfahren zum Herstellen eines RE123-basierten supraleitenden Drahtes (10), das Folgendes umfasst:
Verwenden eines Ziels (20), das BaHfO₃ von 0,5 bis 10 Mol-% enthält, welches in einen Oxidsupraleiter, der durch eine Zusammensetzungsformel von Eu₁Ba₂Cu₃O_{7-δ} ausgedrückt wird, eingeführt wird; oder eines Pulvers,
das ein Bestandselement des Oxidsupraleiters enthält;
Einstellen einer Oberflächentemperatur eines Substrats (11) auf 825 °C bis 875 °C; und
Bilden einer supraleitenden Oxidschicht (14), in der eine andere Phase, die BaHfO₃ enthält, als ein Flussverankerungszentrum dispergiert ist und dessen a-axiales Verhältnis kleiner als oder gleich 1,5 % ist, durch physikalische Dampfphasenabscheidung oberhalb einer Zwischenschicht (12), die oberhalb des Substrats (11) gebildet ist.

## Revendications

1. Fil supraconducteur à base de RE 123 (10) comprenant :
un substrat (11) ;
une couche intermédiaire (12) disposée au-dessus du substrat (11) ; et
une couche supraconductrice à base d'oxyde (14) qui est disposée au-dessus de la couche intermédiaire (12),
**caractérisé en ce que** ladite couche supraconductrice à base d'oxyde (14) est constituée d'un supraconducteur à base d'oxyde exprimé par une formule compositionnelle de Eu₁Ba₂Cu₃O_{7-δ}, dans lequel
de 0,5 à 10 % en moles de BaHfO₃ sont introduits dans la couche supraconductrice à base d'oxyde (14),
une phase différente contenant du BaHfO₃ est dispersée dans la couche supraconductrice à base d'oxyde (14) en tant que centre d'ancrage de flux, et
le rapport d'axe a de la couche supraconductrice à base d'oxyde est inférieur ou égal à 1,5 %.

2. Fil supraconducteur à base de RE 123 (10) selon la revendication 1, dans lequel de de 1,5 à 5,0 % en moles de BaHfO₃ sont introduits dans la couche supraconductrice à base d'oxyde (14).

3. Procédé de fabrication d'un fil supraconducteur à base de RE123 (10), comprenant :
l'utilisation d'une cible (20) contenant de 0,5 à 10 % en moles de BaHfO₃ qui sont introduits dans un supraconducteur à base d'oxyde exprimé par une formule compositionnelle de Eu₁Ba₂Cu₃O_{7-δ}, ou une poudre contenant un élément constitutif du supraconducteur à base d'oxyde ;
le réglage d'une température de surface d'un substrat (11) à 825 °C à 875 °C ; et
la formation, au-dessus d'une couche intermédiaire (12) formée au-dessus du substrat (11), par dépôt physique en phase vapeur, d'une couche supraconductrice à base d'oxyde (14) dans laquelle une phase différente contenant du BaHfO₃ est dispersée en tant que centre d'ancrage de flux et dont le rapport d'axe a est inférieur ou égal à 1,5 %.
